# EUROPEAN PATENT APPLICATION

(11) **EP 1 956 708 A1**
(43) Date of publication of application: **13.08.2008**
(21) Application number: 07024162.5
(22) Date of filing: 12.12.2007
(51) Int. Cl.: H03J 1/00, H03L 7/197, H04B 1/40

(54) **Receiving apparatus**

(30) Priority: 31.01.2007 JP 2007020359
(71) Applicant: NEC Electronics Corporation, Kawasaki, Kanagawa 211-8668 (JP)
(72) Inventor: Nakamura, Yoshiaki, Kawasaki Kanagawa 211-8668 (JP)
(74) Representative: Glawe, Delfs, Moll

(57) **Abstract**

A receiving apparatus includes a voltage-controlled oscillator to generate a local signal, a synchronous unit to receive the local signal and a reference clock, to divide the local signal by an average dividing number obtained by switching a plurality of dividing numbers by time-division, to compare a phase of the local signal with a phase of the reference clock, and to control the voltage-controlled oscillator in order to synchronize the compared phases, and a fixed divider to divide the local signal in a fixed dividing number and to output the divided signal.

## Description

### BACKGROUND OF THE INVENTION

### 1. Field of the Invention

The present invention relates to a receiving apparatus having a PLL (Phase Locked Loop) circuit to generate a local signal synchronized with a reference clock, a mixer to down-convert a receiving signal using the local signal, and a baseband processing unit to perform signal processing. Especially, the receiving apparatus has an oscillator to provide the reference clock for the baseband processing unit and PLL circuit directly or indirectly.

### 2. Description of Related Art

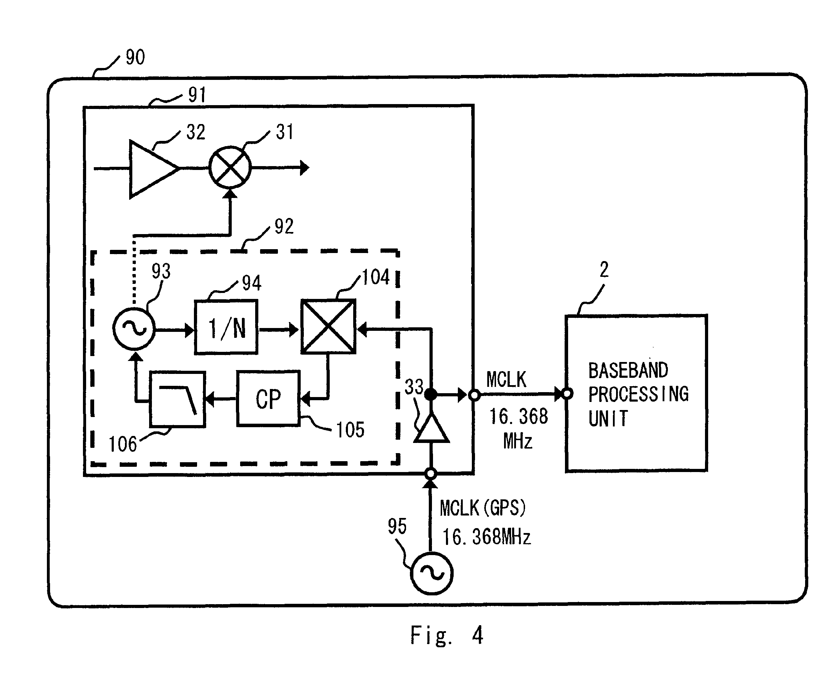

Recently, GPS (Global Positioning System) receivers have widely been used. There is a cellular telephone equipped with the GPS receiver. Fig. 4 shows the configuration of a GPS receiver. In a GPS receiver 90, the reference clock (a main clock, a reference signal) is oscillated by temperature-compensated crystal oscillator (TCXO) or the like. The reference clock is provided to a baseband processing unit 2 and an RF (Radio Frequency) converter 91 directly or indirectly through a buffer in the RF converter 91. For example, in the baseband processing unit 2, a frequency of the reference clock is determined in view of a speed of signal processing, power consumption, problems of high frequency wave and the like. In the RF converter 91, a PLL circuit 92 is configured based on the frequency determined as the reference clock. There is 16.368 MHz as an example of frequency of the reference clock. The PLL circuit 92 synchronizes phases of signals from a voltage-controlled oscillator or the like to generate a local signal used in the RF converter 91. Product examples of RF converter for GPS receiver is disclosed as follows. "GPS receiver module [GF-0145]", SHINKO ELECTRIC INDUSTRIES CO., LTD., [search on 27.12.2006],
<URL:http://www.shinko.co.jp/product/module-product/gf0145.ht ml>
"GPS RF FRONT-END IC ", STMicroelectronics, [search on 27.12.2006],
<URL:http://www.st-japan.co.jp/products/families/gps/gps_rece iver.htm>,
"µPB1009K", NEC Compound Semiconductor Devices, LTD., [search on 27.12.2006],
<URL:http://www.ncsd.necel.com/microwave/japanese/pdf/PU10425 JJ01V1DS.pdf>

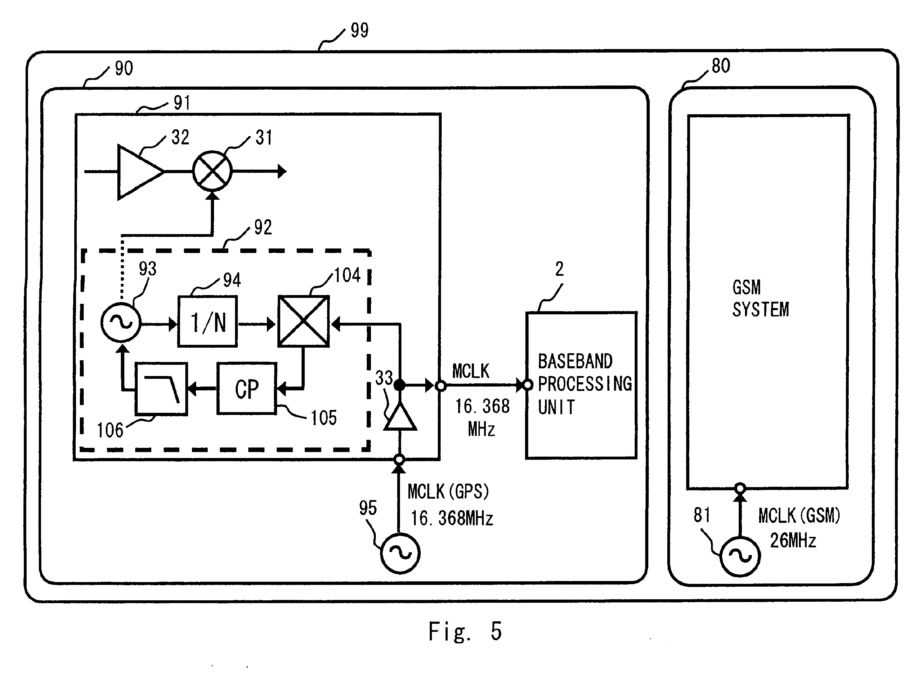

The configuration of the receiver showed in Fig. 4 is suitable for a system to perform GPS function mainly. On the other hand, it is not suitable for a cellular telephone equipped with GPS function, which has been a recent trend. The reason is that a frequency of the reference clock that is specific for GPS such as 16.368 MHz is different from a frequency of the reference clock for each system including the cellular telephone. Thus, the cellular telephone has two reference clock sources. An example of the former frequency is 16.368 MHz. Examples of the latter frequency are 26 MHz (GSM : Global System for Mobile Communications), 19.2 MHz (WCDMA : Wideband Code Division Multiple Access) or the like. When systems such as cellular telephone or the like equip GPS function, the systems have two kinds of reference clock sources in related configuration. Fig. 5 shows a part of the configuration of a cellular telephone equipped with the GPS receiver. In Fig. 5, a GSM system 80 and a GPS receiver 90 have reference clocks 81, 95 respectively.

Examples of features that share one reference clock are disclosed in Japanese Unexamined Patent Application Publication No. 2003-258669, Japanese Unexamined Patent Application Publication (Translation of PCT Application) No. 2005-510166, and Japanese Unexamined Patent Application Publication (Translation of PCT Application) No. 2005-526256.

According to the related art, the features may realize to share one clock. Unfortunately, however a spurious signal occurs when a system divides the frequency of the local signal and uses the divided frequency as the reference clock, for example, the reference signal for GPS baseband.

### SUMMARY

According to one aspect of the present invention, there is provided a receiving apparatus including a voltage-controlled oscillator to generate a local signal, a synchronous unit to receive the local signal and a reference clock, to divide the local signal by an average dividing number obtained by switching the plurality of dividing numbers by time-division, to compare a phase of the local signal with a phase of the reference clock, and to control the voltage-controlled oscillator in order to synchronize the compared phases, and a fixed divider to divide the local signal in a fixed dividing number and to output the divided signal. By employing the fractional divider and the fixed divider, generality of a frequency lineup may be improved and a reference clock of another system may be shared. By employing the fractional divider to synchronize the phases of the reference clock and the local clock and employing the fixed divider to provide the signal with no spurious signal, it is possible to provide a reference signal no spurious signal to a baseband processing unit by sharing the reference clock of another system. According to a preferred embodiment of the present invention, it is possible to provide a local signal and a reference signal (the local divided signal) with no spurious signal using the reference clock of another system. By having such a structure, it is possible to reduce cost and space of receivers such as a cellular telephone and a mobile product.

### BRIEF DESCRIPTION OF THE DRAWINGS

The above and other objects, advantages and features of the present invention will be more apparent from the following description of certain preferred embodiments taken in conjunction with the accompanying drawings, in which:
Fig. 1 is a block diagram showing the configuration of a GPS receiver according to a first embodiment of the present invention;
Fig. 2 is a block diagram showing a part of the configuration of a receiving apparatus equipped with the GPS receiver according to the first embodiment;
Fig. 3 is a block diagram showing a part of the configuration of a converter;
Fig. 4 is a block diagram showing the configuration of a GPS receiver according to a related art; and
Fig. 5 is a block diagram showing a part of the configuration of a cellular telephone equipped with the GPS receiver according to the related art.

### DETAILED DESCRIPTION OF THE PREFERRED EMBODIMENTS

The invention will now be described herein with reference to illustrative embodiments. Those skilled in the art will recognize that many alternative embodiments can be accomplished using the teachings of the present invention and that the invention is not limited to the embodiments illustrated for explanatory purposes.

### First embodiment

Preferred embodiments of the present invention are described with reference to the figures hereinafter. In each figure, components or portions which have same reference numerals have the same function and operate in the same way and hence the overlapping description are omitted.

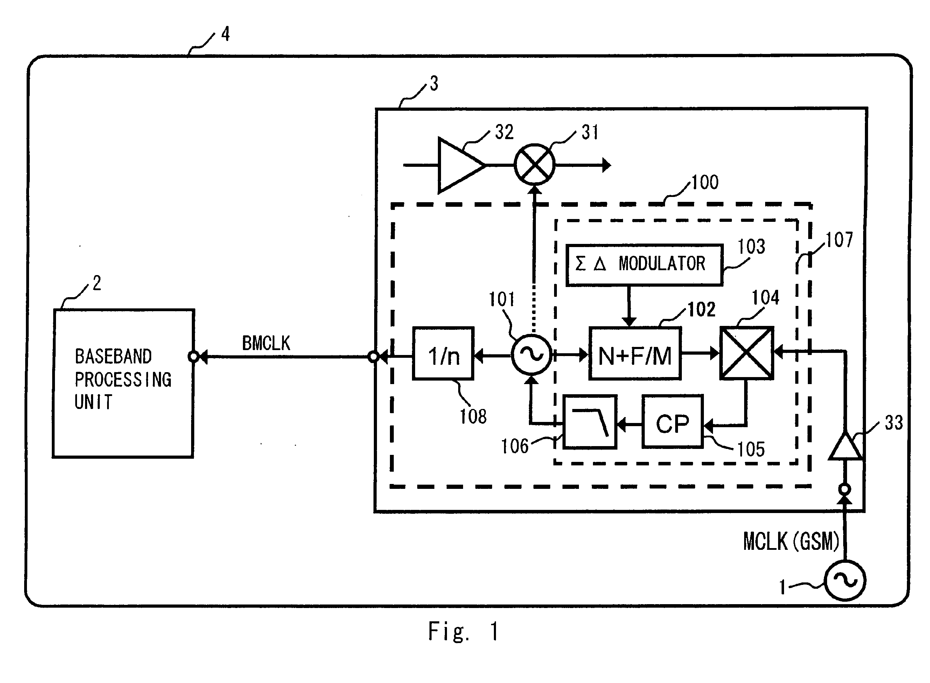

Fig. 1 shows the configuration of a GPS receiver according to a first embodiment of the present invention. In Fig. 1, a GPS receiver (receiving apparatus) 4 includes a reference oscillator 1, a baseband processing unit 2, and an RF converter 3. The RF converter 3 includes a mixer 31, a low noise amplifier (LNA) 32, a buffer 33, and a PLL circuit 100. The PLL circuit 100 includes a voltage-controlled oscillator (hereinafter referred to as "VCO"), 101, a synchronous unit 107, and a fixed divider 108. The reference oscillator 1 generates a reference clock (reference clock signal). In this embodiment, the reference oscillator 1 generates the reference clock having a frequency of 26 MHz. In this description, the reference clock generated by the reference oscillator 1 is also referred to as "MCLK (GSM)".

The signal received by the receiver 4 is down-converted and converted into digital signal. Then the signal is input to the baseband processing unit 2 and the baseband processing unit 2 processes the signal.

The RF converter 3 combines information that is to be transmitted with a carrier wave and separates the information from the carrier wave.

A local signal and the received signal are input to the mixer 31. Then the mixer 31 multiplies the local signal by the received signal to provide an intermediate frequency signal.

The PLL circuit 100 synchronizes the local signal with the reference clock signal and outputs the local signal and the local signal divided by designated dividing number. The components of the PLL circuit 100 are described hereinafter.

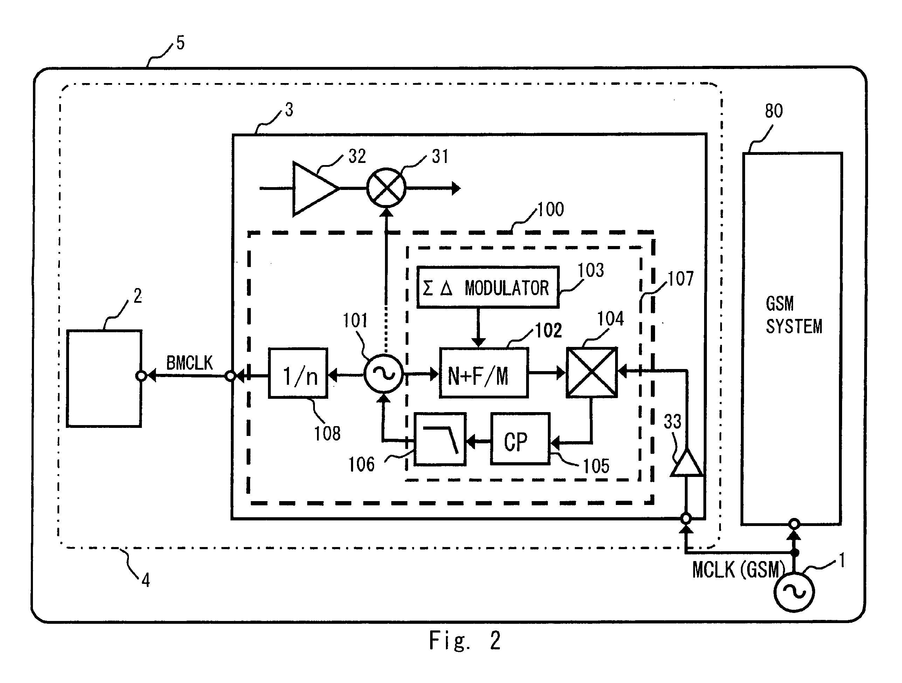

The VCO 101 generates a local signal. The local signal has a frequency that corresponds to the mixer 31. The VCO 101 is controlled by the synchronous unit 107 so as to synchronize phase of the local signal with phase of the reference clock generated by the reference oscillator 1. Specifically, the VCO 101 generates the local signal by controlling an oscillating frequency in accordance with a voltage level output from a loop filter 106. The loop filter 106 is described below. The local signal is provided to the mixer 31. The local signal is also provided to the baseband unit 2 as a baseband main clock (BMCLK) after being divided by the fixed divider 108. In Figs. 1 and 2, a dotted line of an arrow between the VCO 101 and mixer 31 indicates that a divider or the like may be inserted between the VCO 101 and mixer 31.

In Fig. 1, the synchronous unit 107 is illustrated as an example of a fractional N PLL. The synchronous unit 107 includes a fractional divider 102, a ΣΔ modulator (delta-sigma modulator) 103, a phase comparator 104, a charge pump (CP) 105, and the loop filter 106. The synchronous unit 107 performs functions by each component as a whole as follows. The synchronous unit 107 receives the reference clock from the reference oscillator 1 and the local signal from the VCO 101. The synchronous unit 107 divides the local signal by the fractional divider 102, compares the phase of the reference clock with the phase of the divided local signal, and controls the VCO 101 to synchronize the compared phases. Hereinafter, the functions of components are described. The fractional divider 102 divides the local signal to tune a desired frequency. The set desired frequency is such that it is possible compare the phases of the local signal with the reference clock. In Fig. 1, the fractional divider 102 (ΣΔ fractional N) is illustrated as an example. The fractional divider 102 may be replaced with other dividers which have the same functions for switching dividing numbers by time-division and dividing a signal by a fractional number on average. A fixed divider divides the signal by a fixed fractional number. On the other hand, the fractional divider divides the signal using a plurality of dividing numbers by time-division (dynamic switching), to thereby dividing the signal by the fractional number.

In the fractional divider 102, the ΣΔ modulator 103 often switches dividing numbers to use different dividing numbers by time-division. The ΣΔ modulator 103 may be omitted from the PLL circuit 100.

The phase comparator 104 compares the phase of the reference clock generated by reference oscillator 1 with the phase of the local signal divided by the fractional divider 102 and outputs an up signal or a down signal. The pulse width of the up and down signals are set based on the compared phase difference.

The charge pump 105 generates an output voltage of the charge pump depending on the up signal or the down signal output from the phase comparator 104.

The loop filter 106 filters out a noise from the output voltage of the charge pump and outputs filter voltage.

The fixed divider 108 divides the local signal output from the VCO 101 by a fixed dividing number (indicated by "n" in Fig. 1) and outputs the divided local signal. The fixed dividing number is not fractional N and is set in order to tune a desired frequency for each unit. In this embodiment, the fixed divider 108 divides the local signal to tune the desired frequency for the baseband processing unit 2 and outputs the divided local signal as the main clock of baseband to the baseband processing unit 2. The fixed divider 108 may change the frequency of the local signal by choosing a dividing number to tune the desired frequency.

In this specification, the fixed divider uses the fixed dividing number at any time. The fixed divider also generally includes a divider which switches dividing numbers depending on instructions from external devices. However since switching dividing numbers is not dynamic switching, both cases are regarded as the fixed divider in this specification.

As describes above, in the receiving apparatus (GPS receiver 4, for example), the reference clock is not provided to the baseband processing unit 2, but provided to the RF converter 3. The RF converter 3 generates the local signal based on the reference clock, divides the generated local signal, and provides the divided local signal to the baseband processing unit 2. Therefore, the mixer 31 and baseband processing unit 2 use local signals having frequencies different from the reference clock which is not appropriate. The local signals are synchronized with the reference clock by the RF converter 3.

Fig. 2 shows a part of the configuration of a receiving apparatus equipped with the GPS receiver. A receiving apparatus 5 in the Fig. 2 is illustrated as an example of the cellular telephone equipped with the GPS receiver 4. In the receiving apparatus, reference clock generated by the reference oscillator 1 is provided to a GSM system 80 and the GPS receiver 4. The frequency of the reference oscillator 1 is 26 MHz. The receiving apparatus is not limited to the configuration in Fig. 2 but may be the GPS receiver 4 itself.

Advantages to use the fractional divider 102 in the synchronous unit 107 are described hereinafter. The fractional divider, such as the fractional N PLL circuit creates various dividing numbers, but it may generate the spurious signal. On the other hand, the fixed divider only creates simple dividing numbers, but it does not generate the spurious signal. For example, the dividing numbers of the fixed divider are integer denominators such as 1/2, 1/3, 1/4 or the like. The denominator may be decimal number such as 1.5. In this embodiment, the fractional divider 102 is used for synchronizing the phases of the reference clock and the local signal. The fixed divider 108 is employed to provide the baseband processing unit 2 with the divided local signal (the reference signal). As a result, generality of the frequency lineup in synchronizing the reference clock and the local clock increases. The local signal provided to the baseband processing unit 2 dose not have the spurious signal since the fixed divider 108 divides the local signal by fixed dividing number.

Usually, effects of phase noise degradations caused by the spurious signals and a frequency error occurred by using the fractional divider 102 and difficulties of frequency lineup caused by dividing the local signal by the fixed dividing number do not cause any problem when the phases of the local signal and the reference clock are synchronized.

Next, the frequency error and spurious signal occurred by using the fractional divider are set forth in detail by giving numeric value as an example. Referring to Fig. 1, the synchronous unit 107 equipped with fractional N PLL is illustrated as an example. The synchronous unit 107 includes the fractional divider, specifically a "N+F/M" divider, and the ΣΔ modulator 103. The ΣΔ modulator 103 is employed to reduce effects of the spurious signal caused by the fractional divider 102. If we assume that "N+F/M" is 10.1, "N" and "F/M" become N=10 and F/M=0. 1 since "N" indicates integer number and "F/M" indicates fractional number (decimal point). A denominator "M" can be set arbitrary. For example, if we assume that denominator M is 20 bits (M=220=1048576), "F" is calculated as F=104857. 6 because we have assumed that F/M = 0.1. Thus, the fractional divider is composed of "N" divider (1/10 divider) as the fixed divider, and "F/M" divider (104857.6/220 divider) as the fractional divider. The "F/M" divider performs one output per 104857.6 "F" inputs.

First, the frequency error occurred by using the above-described fractional divider is set forth. Because the value of the "F" input is counted by the integer number, 104857. 6 is approximated to 104858. As a result, "N+F/M" divider divides a signal by 10+104858/220=10.100000381. For example, an ideal frequency is 10 MHz when the fractional divider divides frequency of 101 MHz. In practice, the divided frequency becomes 9.999999624 MHz, so that frequency error of about 0.38 Hz occurs. In this regard, when a divider is arranged between the VCO 101 and fractional divider 102 and the synchronous unit 107 synchronizes phases of higher frequency local signal and the reference clock, the frequency error of about 0.38 Hz is amplified by the dividing number of the arranged divider, and the amplified frequency error effects on the local signal.

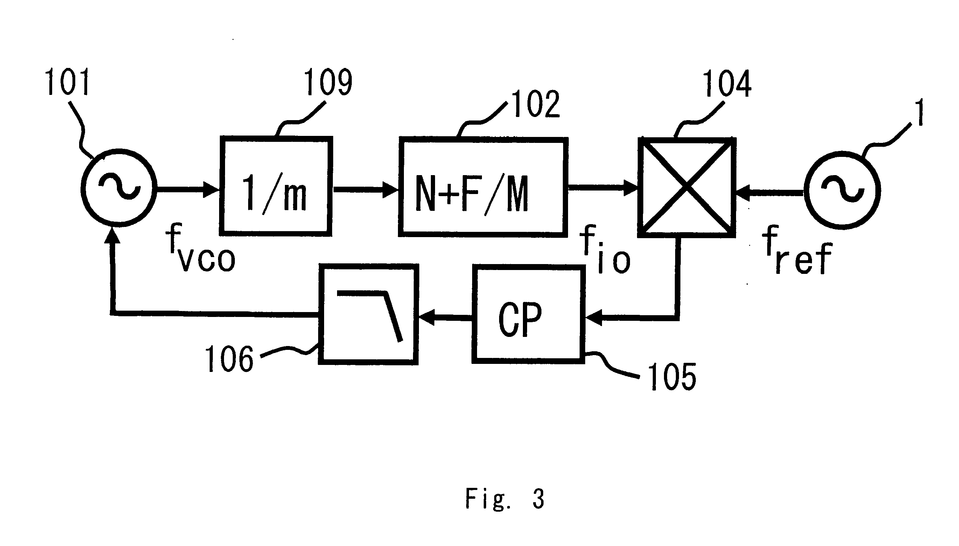

Fig. 3 shows a part of the configuration of a converter. The converter in Fig. 3 shows an example of a divider 109 arranged between the VCO 101 and the fractional divider 102. The divider 109 divides a signal fvco by a dividing number of "m". The signal fvco is output from the VCO 101 as the local signal. A signal fio is output from the fractional divider 102. A signal fref is the reference clock. In Fig. 3, fvco is divided by the dividing number of "m". Therefore the frequency error caused by the fractional divider 102 in the converter becomes 0.38xm Hz. Even when it is assumed that m=100, the frequency error becomes about 38 Hz. Hence, real damage caused by the frequency error can be prevented by using large number of "M".

Next, the spurious signal is set forth. The spurious signal is caused by fractional control executed by the fractional divider 102. Referring to Fig. 3, the spurious signal can be described as frefx(F/M) Hz and fref×{1-(F/M)} Hz. These two spurious signals come out as sideband waves of the voltage-controlled oscillator and affect a phase noise. Usually, one of these two spurious signals which appears near a loop band and has low frequency can be cause a problem. If it is assumed that fref is 26 MHz, strong spurious signal of 26×104858/220≈2. 6MHz may occur. Similarly, if it is assumed that (N+F/M) = 10.3, strong spurious signal of 26×314573/220≈7.8 MHz may occur. If fref is other values, various ranges of spurious signals may also occur. Therefore, some treatment is usually performed to reduce spurious signal when the fractional N PLL is used.

For example, a ΣΔ modulation system (in particular ΣΔ modulator 103) is employed for reducing the spurious signal in Fig. 1. The ΣΔ modulation system realizes the dividing number of 104858/220 by average many dividing numbers. The averaging of many dividing numbers is well known as a method of distributing calculated frequency value obtained by the above expression. However, this is just one of the method of reducing the spurious signal artificially, and it is nothing more than distributing spurious signals to frequencies. Thus, using the fractional N PLL, the spurious signal occurs. Even if any reducing method is executed, it is difficult to expect the effect of the spurious signal on others at designing of whole block.

As described above, the effects of the fractional N PLL caused by using synchronous unit according to the first embodiment of the present invention are as follows.

### (1) Effect of the frequency error to occurred by the fractional N PLL

Error occurred on fvco may not be a problem. As a result, the fractional N PLL is used for synchronizing the local signal (fvco) and the reference clock (fref). It may be convenient in the frequency lineup, and there is no real damage.

### (2) Effect of the spurious signal occurred by the fractional N PLL

When the ΣΔ modulation system is employed, there is no effect on the VCO property (phase noises), as it has been experimented. However, if the output from the fractional divider 102 is used to the clock to the baseband processing unit 2 directly, an adverse effect may occur to the baseband processing unit 2. The adverse effect may be solved by using the divided signal output from the fixed divider 108 which divides the local signal output from the VCO 101.

By using the fractional divider 102 in synchronizing phase and using the fixed divider 108 to provide the divided signal for the baseband processing unit 102, it is possible to synchronize the phases with reducing the spurious signal and to provide the local signal having the frequency necessary to the baseband processing unit 2.

As described above, according to a preferred embodiment of the present invention, the fractional N PLL (for example, the PLL circuit 100) is used for synchronizing the local signal and the reference clock, and the fixed divider 108 is used for providing the local clock for the baseband processing unit 2. As a result, it is possible to improve the generality of the frequency lineup and share the reference clock of other systems.

In Figs. 1 and 2, the PLL circuit 100 includes the ΣΔ modulator 103. However, the ΣΔ modulator 103 is not necessary in a PLL circuit. The ΣΔ modulator 103 may be omitted as long as precision necessary for synchronizing phases is kept, though the spurious signal may be occurred.

It is apparent that the present invention is not limited to the above embodiments, but may be modified and changed without departing from the scope and spirit of the invention.

## Claims

1. A receiving apparatus comprising:
a voltage-controlled oscillator to generate a local signal;
a synchronous unit to receive the local signal and a reference clock, to divide the local signal by an average dividing number obtained by switching a plurality of dividing numbers by time-division, to compare a phase of the local signal with a phase of the reference clock, and to control the voltage-controlled oscillator in order to synchronize the compared phases; and a fixed divider to divide the local signal in a fixed dividing number and to output the divided signal.

2. The receiving apparatus according to claim 1, wherein the synchronous unit includes:
a fractional divider to receive the local signal from the voltage-controlled oscillator, to divide the local signal by a dividing number set to be able to compare with the phase of the reference clock, and to output the divided local signal;
a phase comparator to compare the phase of the reference clock with the phase of the divided local signal and to output one of an up signal and a down signal having a pulse width set based on the compared phase difference;
a charge pump to generate an output voltage of the charge pump depending on one of the up signal and the down signal; and
a loop filter to generate a filter voltage with a noise filtered out from the output voltage of the charge pump,
wherein the voltage-controlled oscillator generates the local signal by controlling an oscillating frequency depending on a voltage level of the filter voltage.

3. The receiving apparatus according to claim 2, wherein the fractional divider employs ΣΔ modulation system.

4. The receiving apparatus according to claim 1, wherein
the voltage-controlled oscillator outputs the local signal into a mixer, and
the fixed divider divides the local signal to tune a frequency of a reference signal for a baseband processing unit.

5. The receiving apparatus according to claim 2, wherein the voltage-controlled oscillator outputs the local signal into a mixer, and
the fixed divider divides the local signal to tune a frequency of a reference signal for a baseband processing unit.

6. The receiving apparatus according to claim 3, wherein
the voltage-controlled oscillator outputs the local signal into a mixer, and
the fixed divider divides the local signal to tune a frequency of a reference signal for a baseband processing unit.

7. The receiving apparatus according to claim 1, wherein
the synchronous unit, the voltage-controlled oscillator, and the mixer perform to down-convert a signal transferred from GPS (Global Positioning System) satellite, and
the reference clock has a unique frequency of a reference clock of a cellular telephone.

8. The receiving apparatus according to claim 2, wherein
the synchronous unit, the voltage-controlled oscillator, and the mixer perform to down-convert a signal transferred from GPS (Global Positioning System) satellite, and
the reference clock has a unique frequency of a reference clock of a cellular telephone.

9. The receiving apparatus according to claim 3, wherein
the synchronous unit, the voltage-controlled oscillator, and the mixer perform to down-convert a signal transferred from GPS (Global Positioning System) satellite, and
the reference clock has a unique frequency of a reference clock of a cellular telephone.

10. The receiving apparatus according to claim 4, wherein
the synchronous unit, the voltage-controlled oscillator, and the mixer perform to down-convert a signal transferred from GPS (Global Positioning System) satellite, and
the reference clock has a unique frequency of a reference clock of a cellular telephone.
